# EUROPÄISCHE PATENTSCHRIFT

(11) **EP 1 211 801 B1**
(45) Veröffentlichungstag und Bekanntmachung des Hinweises auf die Patenterteilung: **27.07.2005**
(21) Anmeldenummer: 01126314.2
(22) Anmeldetag: 06.11.2001
(51) Int. Cl.: H03C 5/00, H03C 3/09

(54) **Polar-Loop-Sendeschaltung**
Polar Loop Transmitter
Emetteur utilisant une boucle polaire

(30) Priorität: 15.11.2000 DE 10056472
(43) Veröffentlichungstag der Anmeldung: 05.06.2002
(73) Patentinhaber: Infineon Technologies AG, 81669 München (DE)
(72) Erfinder: Asam, Michael, 85250 Wollomoos (DE); Herzinger, Stefan, 80686 München (DE); Kraut, Gunther, 85375 Neufahrn (DE); Simon, Martin, 83624 Otterfing (DE); Zhang, Xiaopin, 80805 München (DE)
(74) Vertreter: Epping Hermann & Fischer

(56) Entgegenhaltungen:
- EP-A- 0 638 994
- US-A- 4 481 672
- US-A- 5 430 416

## Beschreibung

Die vorliegende Erfindung betrifft eine Polar-Loop-Sendeschaltung.

Der GSM(Global System for Mobile Communications)-Standard ist der weltweit bei weitem erfolgreichste Mobilfunkstandard. Als Vielfachzugriffsverfahren, mit dem mehrere Teilnehmer zeitgleich mit einer Basisstation kommunizieren können, wird ein Zeitvielfachzugriffsverfahren, Time Division Multiple Access TDMA, eingesetzt. Als Modulationsverfahren auf dem Funkkanal wird bei GSM das sogenannte GMSK, Gauß'sches Minimum Shift Keying, verwendet, welches zur Familie der kontinuierlichen Phasenmodulationsverfahren gezählt wird. GMSK ist insbesondere dadurch gekennzeichnet, daß seine modulierten Signale eine konstante Einhüllende aufweisen, so daß sendeseitig einfache, nichtlineare Verstärker verwendbar sind.

Um den beispielsweise durch Internet-Anwendungen gestiegenen Bandbreite-Bedarf im Mobilfunk Rechnung zu tragen, soll neben der bei GSM verwendeten Phasenmodulation zusätzlich eine Amplitudenmodulation im Funkkanal eingesetzt werden. Zu übertragende Information wird dann nicht nur in der Signalphase, sondern auch in der Signalamplitude codiert. Die Einhüllende des Modulationssignals ist dann nicht mehr konstant. Zu einer derartigen, phasen- und amplitudengetreuen Signalübertragung sind lineare Senderkonzepte erforderlich.

Neben Kostenaspekten ist bei Mobilfunk-Schaltungen ein geringer Energiebedarf beziehungsweise ein hoher Wirkungsgrad der Schaltungskomponenten wichtig, um lange Laufzeiten der Geräte bei kleinen und leichten Batterien oder Akkumulatoren zu erreichen.

Eine Möglichkeit, eine lineare Senderarchitektur zu erhalten, ist gekennzeichnet durch den Einsatz eines linearen Leistungsverstärkers (PA, Power Amplifier), an den über einen Isolator eine Sendeantenne anschließbar ist. Lineare Leistungsverstärker haben jedoch einen geringeren Wirkungsgrad von ca. 25% bis 35% gegenüber den beim herkömmlichen GSM-Standard verwendbaren nichtlinearen Leistungsverstärkern, welche einen Wirkungsgrad von ca. 50% erreichen. Der Wirkungsgrad ist dabei als Quotient aus gesendeter Hochfrequenzleistung und eingesetzter Gleichstromleistung angegeben. Neben einem erhöhten Energiebedarf ist der erforderliche Isolator am Antennenausgang sowie die bei diesem Konzept erforderliche, aufwendige Leistungsregelung mit Einbeziehung des Basisbands nachteilig. Denn auch während des Betriebs, sogar während eines Sende-Zeitschlitzes (Burst), können sich aufgrund von Temperaturschwankungen, Versorgungsspannungsschwankungen etc. die Verstärkungseigenschaften der Leistungs-Endstufe ändern. Zudem können Meß-Bursts beim Einmessen des Senders zu Spezifikationsverletzungen der zugelassenen Sendeleistung führen.

In dem Dokument US 4,481,672 ist ein Polar-Loop-Sender angegeben. Dabei wird ein zu sendendes Eingangssignal, welches von einem SSB-Generator bereitgestellt wird, sowie ein rückgekoppeltes Ausgangssignal, welches mit einem Attenuator gedämpft und mit einem Mischer in eine tiefere Frequenzebene konvertiert ist, jeweils in seine Polar-Komponenten, das heißt in Amplitude und Phase, zerlegt. Hierfür ist ein "Polar Resolver" vorgesehen, der zwei Limiter zur Gewinnung der Phaseninformation umfaßt. Ein Oszillator wird mit einem Phasendetektor angesteuert, dem die Phasenlagen beider Signale zugeführt sind. Weiterhin ist ein Differenzverstärker vorgesehen, der die Amplituden der beiden Signale vergleicht und die Einhüllende eines vom Oszillator erzeugten Hochfrequenzsignals moduliert. Das Hochfrequenzsignal wird anschließend mit einem Power Amplifier verstärkt und gefiltert, so daß ein Sendesignal bereitsteht. Zur Vermeidung negativer Spikes ist zusätzlich eine Spitzenwertabtastung vorgesehen. Der Polar-Loop-Sender mit Rückkopplungszweig kann auch als Phasenregelschleife (PLL, Phase Locked Loop) interpretiert werden. Dem Dokument sind keine Hinweise auf Vielfachzugriffsverfahren entnehmbar.

Das Dokument EP 0 638 994 A1 zeigt einen Sender und einen Leistungsverstärker. Die Ausgangsstufe des Leistungsverstärkers hat eine Rückführungsschleife. Je ein Verstärkungssteuerungselement ist im Vorwärtspfad und im Rückführungspfad vorgesehen. Das Verstärkungssteuerungselement im Rückführungspfad steuert den Sendepegel an der Antenne. Mit dem Verstärkungssteuerungselement im Vorwärtspfad wird die Schleifenverstärkung auf einem konstanten Pegel gehalten.

Aufgabe der vorliegenden Erfindung ist es, eine Polar-Loop-Sendeschaltung anzugeben, welche für Mobilfunksysteme mit Phasen- und Amplitudenmodulation und zum Senden in Zeitschlitzen geeignet ist und zusätzlich einen geringen Energiebedarf hat.

Erfindungsgemäß wird die Aufgabe mit einer Polar-Loop-Sendeschaltung gelöst mit den Merkmalen des Patentanspruchs 1.

Bei vorliegender Sendeschaltung kann die als Amplitudenmodulator bezeichnete Leistungs-Endstufe als nichtlinearer Verstärker ausgeführt sein, welcher in Sättigung betrieben werden kann. Damit kann ein Verstärker mit großem Wirkungsgrad von beispielsweise 50% eingesetzt werden.

Die beschriebene Polar-Loop-Architektur mit ihrer Zerlegung von Sendesignal und Rückkopplungssignal jeweils in Amplitude und Phase zeigt insgesamt lineare Übertragungseigenschaften. Demnach können Eingangssignale über einen Funkkanal übertragen werden, welche neben einer Phasenmodulation eine zusätzliche Amplitudenmodulation haben.

Im Rückkopplungspfad ist ein Verstärker vorgesehen, dem eingangsseitig das Ausgangssignal der Sendeschaltung zuführbar ist und der ausgangsseitig mit einem als Abwärtsmischer ausgeführten ersten Mischer verbunden ist. Dieser Verstärker ist als linearer Verstärker ausgeführt und ist vorzugsweise zur Dämpfung des Ausgangssignals geeignet ausgelegt. Dieser lineare Verstärker ermöglicht eine kontrollierte Leistungspegeleinstellung des Ausgangssignals. Weiterhin ermöglicht der Verstärker im Rückkopplungspfad die Erfüllung von TDMA-Spezifikationen, insbesondere bezüglich der Sende-Zeitschlitze (Bursts) beispielsweise beim Modulationsverfahren 8PSK, Phase Shift Keying oder anderen Quadraturamplitudenmodulationen (QAM).

Der hohe, insbesondere mit einem nichtlinearen Amplitudenmodulator erzielbare Gesamtwirkungsgrad der beschriebenen Sendeschaltung ermöglicht lange Sprechzeiten beziehungsweise lange Betriebszeiten der Schaltung sowie die Verwendung kleiner Batterien oder Akkumulatoren bei mobilen Anwendungen. Insbesondere im Mobilfunk ist dies besonders vorteilhaft.

Die Leistungspegel-Einstellbarkeit mit dem Verstärker im Rückkopplungspfad vermindert den Aufwand des Leistungspegelabgleiches bei der Fertigung. Durch Anordnung des linearen Verstärkers zu Beginn des Rückkopplungspfades können die im Rückkopplungspfad nachgeschalteten Bauteile für geringere Dynamik ausgelegt sein und einen einfachen Aufbau haben. Die Sendeschaltung zeigt geringe Empfindlichkeit gegenüber Temperatur- und Betriebsspannungsschwankungen und Rückwirkungen einer am Ausgang anschließbaren Antenne, so daß ein Isolator am Ausgang des Amplitudenmodulators entfallen kann.

Gemäß der Erfindung umfaßt das Mittel zum Bereitstellen des Phasenvergleichssignals einen Phasen- und Frequenzdetektor mit nachgeschaltetem Tiefpaß-Filter sowie einen ersten Limiter, dem das Zwischenfrequenz-Signal zuführbar ist und einen zweiten Limiter, dem das Eingangssignal zuführbar ist, wobei die Limiter ausgangsseitig an je einen Eingang des Phasen- und Frequenzdetektors anschließbar sind. Der Eingang des ersten Limiters kann mit dem Ausgang des ersten Mischers gekoppelt sein. Der Eingang des zweiten Limiters kann mit dem Generator verbunden sein. Der Generator kann als Single-Sideband-Generator, aber auch allgemein als Modulationsgenerator ausgeführt sein. Der Ausgang des ersten Limiters kann, beispielsweise über einen Schalter, an einen Eingang des Phasen- und Frequenzdetektors angeschlossen sein. Der Ausgang des zweiten Limiters kann mit einem weiteren Eingang des Phasen- und Frequenzdetektors verbunden sein. Der Ausgang des Phasen- und Frequenzdetektors kann mit dem Eingang eines Tiefpaß-Filters verbunden sein. Der Ausgang des Tiefpaß-Filters kann an einen Eingang des Oszillators angeschlossen sein. Der Oszillator kann ein spannungsgesteuerter Oszillator sein.

Der Phasen- und Frequenzdetektor kann zur Bildung einer Differenz einer Soll- und einer Ist-Phase ausgelegt sein, das heißt zur Differenzbildung der Phasenlagen von Eingangssignal und Zwischenfrequenz-Signal.

Gemäß der vorliegenden Erfindung ist auch ein Bypass-Zweig vorgesehen, der einen zweiten Mischer umfaßt, der an den Ausgang des Oszillators angeschlossen ist und der an seinem Ausgang ein weiteres Zwischenfrequenz-Signal bereit stellt, welches dem Phasen- und Frequenzdetektor an einem Eingang als Soll-Signal zuführbar ist. Die beschriebene Sendeschaltung ist für das Senden in Zeitschlitzen (Bursts) geeignet. Bis zum Beginn eines Sende-Zeitschlitzes steht jedoch kein verwertbares Ausgangssignal zur Verfügung, so daß auch kein Rückkopplungssignal im Phasen- und Frequenzdetektor zum Einschwingen der Regelschleife herangezogen werden kann. Hierfür ist der Bypass-Zweig geeignet, der vor Beginn eines Sende-Zeitschlitzes aktiv ist und ein am Oszillator VCO ableitbares Signal mit dem zweiten Mischer in ein Zwischenfrequenz-Signal konvertiert, welches, beispielsweise über einen Schalter, dem Phasen- und Frequenzdetektor an einem Eingang zuführbar ist. Der zweite Mischer kann dabei an den gleichen Lokaloszillator angeschlossen sein, an dem auch der erste Mischer angeschlossen sein kann.

Dadurch, daß mit dem Bypass-Zweig schon vor Sendebeginn eine Regelschleife geschlossen ist, kann bereits vor Sendebeginn ein Einrasten der Gesamtanordnung, welche als PLL (Phasenregelschleife) interpretierbar ist, erfolgen.

Um eine Abwärtskompatibilität mit den im bisherigen GSM-System eingesetzten GMSK-Modulationsverfahren zu gewährleisten, kann es wünschenswert sein, sogenannte Dual-Mode Mobilfunkgeräte aufzubauen. Dabei ist mit dem beschriebenen Prinzip lediglich ein nichtlinearer Leistungsverstärker im Sender erforderlich, nicht jedoch ein nichtlinearer für GMSK sowie ein linearer, beispielsweise für 8PSK. Bei Dual-Band-Geräten können sogar zwei Leistungsverstärker entfallen, da lediglich zwei nichtlineare Leistungsverstärker anstelle zweier nichtlinearer und zweier linearer Endstufen notwendig sind. Dual-band-Mobilfunkgeräte sind dabei beispielsweise für den GSM-Standard im 900 MHz-Band und im 1800 MHz-Band geeignet.

Insgesamt ist die beschriebene Polar-Loop-Sendeschaltung mit geringer Chipfläche, geringem Kostenaufwand und einer einfachen Anbindung an einen Basisband-Baustein aufbaubar. Die Polar-Loop-Architektur kann eine Linearisierung einer nichtlinearen Endstufe oder eines nichtlinearen Amplitudenmodulators bezüglich der Sendedaten bewirken, dabei werden die Sendedaten phasen- und amplitudentreu verstärkt.

In einer weiteren, vorteilhaften Ausführungsform der vorliegenden Erfindung ist der Amplitudenmodulator ein nichtlinearer, regelbarer Verstärker. Nichtlineare Verstärker, beispielsweise Klasse C-Verstärker, haben gegenüber linearen Verstärkern einen deutlich höheren Wirkungsgrad und damit einen geringeren Stromverbrauch.

In einer weiteren, vorteilhaften Ausführungsform der Erfindung ist der Verstärker im Rückkopplungspfad ein programmierbarer Verstärker (PGC, Programmable Gain Control), der das Ausgangssignal dämpft. Dabei ist die Dämpfung des Verstärkers um so höher, je größer der Signalpegel am Ausgangssignal ist. Der programmierbare Verstärker stellt dabei an seinem Ausgang einen, abgesehen von durch die Amplitudenmodulation bedingten Schwankungen, konstanten Signalpegel bereit. Der Verstärker ist bezüglich seines Eingangssignals, das heißt bezüglich des Ausgangssignals der Sendeschaltung, ein linearer Verstärker, der ein an seinem Eingang anliegendes Signal linear dämpft.

In einer weiteren, vorteilhaften Ausführungsform ist dem Steueranschluß des Verstärkers im Rückkopplungszweig ein Steuersignal zuführbar. Mit diesem Steuersignal ist der Ausgangs-Leistungspegel der gesamten Anordnung regelbar. Das Steuersignal ist demnach ein Soll-Verstärkungssignal. Da der Verstärker im Zweig einer negativen Rückkopplung angeordnet ist, ist der Ausgangspegel am Ausgang des Amplitudenmodulators um so größer, je geringer die Verstärkung des programmierbaren Verstärkers ist.

In einer weiteren, bevorzugten Ausführungsform der Erfindung ist ein Schalter vorgesehen, der abhängig von seiner Schalterstellung entweder den Ausgang des ersten Limiters mit einem Eingang des Phasen- und Frequenzdetektors verbindet oder den Ausgang des zweiten Mischers mit einem Eingang des Phasen- und Frequenzdetektors verbindet.

In einer weiteren, bevorzugten Ausführungsform der vorliegenden Erfindung umfaßt das Mittel zum Bereitstellen des Amplitudenmodulationssignals einen Differenzverstärker mit einem Plus-Eingang und einem Minus-Eingang und mit nachgeschaltetem Tiefpaß-Filter, wobei den Plus-Eingang das gleichgerichtete Eingangssignal und dem Minus-Eingang das gleichgerichtete Zwischenfrequenz-Signal zuführbar ist.

Zum Gleichrichten von Eingangs- und Zwischenfrequenz-Signal kann je ein Gleichrichter vorgesehen sein, von denen ein erster Gleichrichter eingangsseitig am Generator und ausgangsseitig mit einem Eingang des Differenzverstärkers, und ein zweiter eingangsseitig mit dem Rückkopplungspfad und ausgangsseitig mit einem weiteren Eingang des Differenzverstärkers verbunden sein kann. An einem Ausgang des Differenzverstärkers kann ein Tiefpaß-Filter angeschlossen sein, welches an seinem Ausgang mit dem Steuereingang des Amplitudenmodulators verbunden sein kann.

In einer bevorzugten Ausführungsform der Erfindung ist zur Gleichrichtung von Eingangssignal und Zwischenfrequenz-Signal je ein Diodengleichrichter vorgesehen. Diodengleichrichter sind besonders einfach implementierbar.

In einer weiteren, vorteilhaften Ausführungsform der vorliegenden Erfindung kann zur Gleichrichtung von Eingangs- und Zwischenfrequenz-Signal je ein Synchrongleichrichter vorgesehen sein. Die Synchrongleichrichter können dabei zur Gewinnung der Signal-Einhüllenden zusätzlich über Hilfseingänge mit dem jeweilig zugehörigen limitierten Signal, beispielsweise mit den Ausgängen der Limiter, verbunden sein.

In einer weiteren, bevorzugten Ausführungsform der vorliegenden Erfindung ist im Rückkopplungspfad ein Ramping-Verstärker vorgesehen, der als linearer, regelbarer Verstärker ausgeführt ist. Dieser dient zum Einregeln der Leistung des Ausgangssignals zu Beginn und am Ende von Sende-Zeitschlitzen. Der Ramping-Verstärker ist dabei bevorzugt mit seinem Eingang an den Ausgang des ersten Mischers angeschlossen.

Weitere Einzelheiten der Erfindung sind Gegenstand der Unteransprüche.

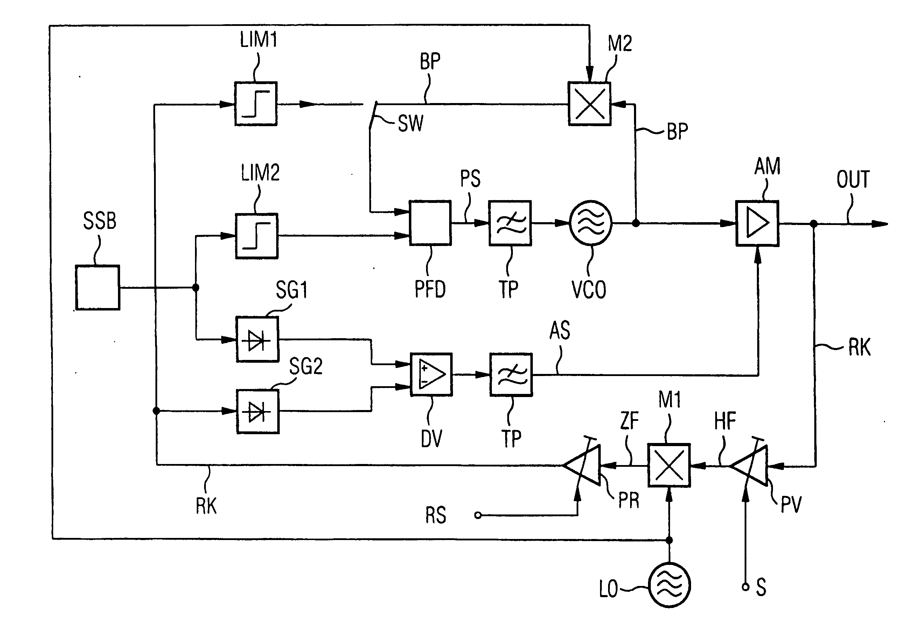

Nachfolgend wird die Erfindung an einem Ausführungsbeispiel anhand der Figur näher erläutert.

Es zeigt:
Die Figur ein erstes Ausführungsbeispiel der Erfindung anhand eines Blockschaltbilds.

Die Figur zeigt eine Polar-Loop-Sendeschaltung mit einem Generator SSB, der an seinem Ausgang ein als Einzelseitenband(Single Side Band)-Signal ausgeführtes Signal bereitstellt. Der Ausgang des Generators ist zur Zerlegung des Eingangssignals in Polarkoordinaten an je einen Eingang eines Limiters LIM2 und eines Diodengleichrichters SG1 angeschlossen. Der Limiter LIM2 stellt an seinem Ausgang eine Phaseninformation des Eingangssignals bereit, während am Ausgang des Diodengleichrichters SG1 die Amplitude oder Einhüllende des Eingangssignals ableitbar ist. In einem Phasen- und Frequenzdetektor PFD wird die vom Limiter LIM2 bereitgestellte Soll-Phaseninformation mit einer von einem Limiter LIM1 bereit gestellten Ist-Phaseninformation durch Differenzbildung der Phasenlagen verglichen. Folgerichtig stellt der Phasen- und Frequenzdetektor PFD an seinem Ausgang ein Phasenvergleichssignal PS bereit. Der Eingang des Limiters LIM1 ist dabei an einen Rückkopplungspfad RK angeschlossen. An den Ausgang des Phasen- und Frequenzdetektors PFD ist ein Tiefpaß-Filter TP angeschlossen, an dessen Ausgang wiederum ein spannungsgesteuerter Oszillator VCO angeschlossen ist. Ein als Leistungsverstärker ausgeführter Amplitudenmodulator AM, der ein nichtlinearer, in Sättigung betriebener Verstärker ist, ist mit seinem Eingang an den Ausgang des spannungsgesteuerten Oszillators VCO angeschlossen. Der Amplitudenmodulator AM weist einen Steuereingang auf, dem ein Amplitudenmodulationssignal AS zuführbar ist. Dieses Amplitudenmodulationssignal AS wird von einem Differenzverstärkers DV bereitgestellt, an dessen Ausgang ein Tiefpaß-Filter angeschlossen ist, wobei der Ausgang des Tiefpaß-Filters TP mit dem Steuereingang des Amplitudenmodulators AM verbunden ist. Der Differenzverstärker DV weist einen nicht-invertierenden Eingang auf, an dem ein erster Diodengleichrichter SG1 angeschlossen ist und einen invertierenden Eingang, an dem ein zweiter Diodengleichrichter SG2 angeschlossen ist. Der Eingang des ersten Diodengleichrichters SG1 ist mit dem Generator SSB verbunden, der erste Diodengleichrichter SG1 stellt demnach an seinem Ausgang die Amplitudeninformation des Eingangssignals als Soll-Wert bereit. Der Eingang des zweiten Diodengleichrichters SG2 ist an den Rückkopplungspfad RK angeschlossen und stellt an seinem Ausgang die Amplitudeninformation beziehungsweise die Einhüllende eines vom Ausgangssignal abgeleiteten Signals als Ist-Wert bereit. Der Rückkopplungspfad RK beginnt am Ausgang des Amplitudenmodulators AM, der mit einem Eingang eines programmierbaren Verstärkers PV verbunden ist. Der programmierbare Verstärker PV weist einen Steueranschluß S auf. Der Ausgang des programmierbaren Verstärkers PV ist an einen ersten Eingang eines ersten Mischers M1 angeschlossen. An einen weiteren Eingang des ersten Mischers M1 ist ein Lokaloszillator LO angeschlossen. Der erste Mischer M1 stellt an seinem Ausgang ein Zwischenfrequenz-Signal ZF bereit, welches eine Trägerfrequenz aufweist, die sich durch Subtraktion der Trägerfrequenz von Hochfrequenz-Signal HF und Lokaloszillatorsignal ergeben kann.

An den Ausgang des ersten Mischers M1 ist mit seinem Eingang ein Ramping-Verstärker PR angeschlossen, dessen Ausgang zum einen mit dem Eingang des Limiters LIM1 und zum anderen mit dem Eingang des Diodengleichrichters SG2 verbunden ist. Der Ramping-Verstärker PR weist einen Anschluß zur Zuführung eines Ramping-Signals RS auf.

Der Lokaloszillator LO ist weiterhin mit einem Eingang eines zweiten Mischers M2 verbunden, der das Ausgangssignal des spannungsgesteuerten Oszillators VCO in ein weiteres Zwischenfrequenzsignal heruntersetzt. Hierfür ist ein weiterer Eingang des zweiten Mischers M2 an den Ausgang des spannungsgesteuerten Oszillators VCO angeschlossen. Der zweite Mischer M2 ist mit seinem Ausgang an einen Schalter SW angeschlossen, der das Ausgangssignal des zweiten Mischers M2 auf einen Eingang des Phasen- und Frequenzdetektors PFD durchschalten kann.

Am Hochfrequenzausgang OUT ist beispielsweise eine Sendeantenne anschließbar. Das am Hochfrequenzausgang OUT bereit gestellte Ausgangssignal ist dabei das phasen- und amplitudentreu verstärkte Eingangssignal, welches am Ausgang des Generators SSB bereitgestellt ist.

Das am Hochfrequenzausgang OUT der Sendeschaltung bereit gestellte Ausgangssignal wird mit dem programmierbaren Verstärker PV in dem Rückkopplungspfad gedämpft. An dessen Ausgang steht somit ein Hochfrequenz-Signal HF mit definiertem Leistungspegel an, welcher, abgesehen von durch die Amplitudenmodulation hervorgerufenen Schwankungen, konstant ist. Am Steueranschluß S kann mit einem Steuersignal der Leistungspegel am Ausgang OUT geregelt werden. Dabei ist der programmierbare Verstärker PV ein linearer Verstärker, der das an seinem Eingang zuführbare Signal linear dämpft. Die Spannung des an seinem Ausgang bereitgestellten Hochfrequenz-Signals HF hingegen hängt nichtlinear von einem an Steueranschluß S zuführbaren Stellsignal ab und beträgt im vorliegenden Beispiel 2dB pro Least-Significant-Bit-Änderung des Stellsignals. Mittels eines vom Lokaloszillator LO erzeugbaren Lokaloszillator-Signals setzt der erste Mischer M1 das Hochfrequenz-Signal HF in ein Zwischenfrequenz-Signal ZF herunter. Der Power-Ramping-Verstärker PR, dem an seinem Eingang das Zwischenfrequenz-Signal ZF zuführbar ist, bewirkt zu Beginn eines Sende-Zeitschlitzes (Burst) ein kontrolliertes Hochregeln der Leistung des Ausgangssignals am Ausgang OUT, sowie entsprechend zu Ende von Sende-Zeitschlitzen ein kontrolliertes Herunterregeln der Ausgangsleistung am Ausgang OUT. Hierzu weist der Ramping-Verstärker PR einen Steuereingang auf, dem ein Ramping-Signal RS zuführbar ist, welches einen Verstärkungs- oder Dämpfungsfaktor des Ramping-Verstärkers PR steuert.

Durch Aktivieren des Bypass-Pfades BP mit dem Schalter SW wird bereits vor Beginn des Sende-Zeitschlitzes ein Einrasten der Phasenregelschleife bewirkt, so daß zu Beginn des Sende-Zeitschlitzes der Schalter SW umgeschaltet wird derart, daß der Ausgang des Limiters LIM1 mit einem Eingang des Phasen- und Frequenzdetektors PFD verbunden ist, erst dann setzt das rampenförmige Hochregeln der Ausgangsleistung der Sendeschaltung ein.

Da der Leistungsverstärker, hier als Amplitudenmodulator AM ausgeführt, in Sättigung betrieben wird, die notwendige Linearität der Gesamtanordnung jedoch mittels des Rückkopplungspfades RK in einer Polar-Loop-Sendearchitektur erreicht wird, ist der Betrieb der Schaltung mit geringem Energiebedarf möglich.

Die Schaltungsmerkmale mit Ramping-Verstärker PR und Bypass-Pfad BP erlauben eine kontrollierte Leistungspegel-Einstellung am Ausgang OUT und erlauben somit die Einhaltung von Spezifikations-Grenzwerten, welche üblicherweise bei TDMA-Systemen vorgesehen sind.

Da der Amplitudenmodulator AM als nichtlinearer, regelbarer Leistungsverstärker ausgeführt ist, weist er einen hohen Wirkungsgrad auf, das heißt der Quotient aus Ausgangsleistung und eingesetzter Gleichstromleistung ist verhältnismäßig groß und liegt im beschriebenen Beispiel bei 50%.

Bei vorliegender Sendeschaltung ist am Ausgang OUT kein Isolator erforderlich.

Der Generator SSB kann auch als Generator ausgeführt sein, der an seinem Ausgang ein moduliertes Signal bereitstellt.

Durch die Anordnung des programmierbaren Verstärkers PV zu Beginn des Rückkopplungspfades RK können die folgenden Stufen im Rückkopplungspfad für geringe Dynamik ausgelegt sein, sollten jedoch hohen Linearitätsanforderungen genügen.

Das beschriebene Regelkonzept führt zu einer weitgehenden Kompensation von Temperaturschwankungen und Betriebsspannungsschwankungen. Zudem kann der üblicherweise bei der Gerätefertigung anfallende, aufwendige Leistungspegelabgleich und der damit verbundene, zu treibende Aufwand deutlich verringert werden.

Der beschriebene Amplitudenmodulator, der als nichtlinearer Verstärker ausgeführt ist und der gelegentlich auch als Power-Amplifier, Leistungsverstärker bezeichnet wird, kann zugleich in einem herkömmlichen GMSK-Modulationsverfahren, welches beim etablierten GSM-Standard eingesetzt ist, als Leistungsverstärker dienen, so daß bei zukünftigen Dual-Mode-Geräten nicht zwei Leistungsverstärker, nämlich ein nichtlinearer und ein linearer, sondern lediglich ein Leistungsverstärker, nämlich ein nichtlinearer, erforderlich ist. Dies führt zu geringerem Aufwand, beträchtlicher Kostenersparnis und Chipflächen- beziehungsweise Leiterplattenplatz-Ersparnis.

Die beschriebene Sendearchitektur eignet sich besonders zur Anwendung bei zukünftigen Mobilfunksystemen, welche auf Modulationsverfahren beruhen, die neben einer Phasenmodulation zusätzlich eine Amplitudenmodulation aufweisen.

## Patentansprüche

1. Polar-Loop-Sendeschaltung mit
- einem Generator (SSB), der ein Eingangssignal bereitstellt,
- einem Oszillator (VCO) zur Erzeugung eines Hochfrequenz-Signals an seinem Ausgang in Abhängigkeit von einem Phasenvergleichssignal (PS),
- einem Amplitudenmodulator (AM), der an den Ausgang des Oszillators (VCO) angeschlossen ist und an seinem Ausgang (OUT) in Abhängigkeit von einem Amplitudenmodulationssignal (AS) ein vom Hochfrequenz-Signal abgeleitetes Ausgangssignal bereitstellt,
- einem Rückkopplungspfad (RK) mit einem ersten Mischer (M1), der an seinem Ausgang ein vom Ausgangssignal abgeleitetes Zwischenfrequenz-Signal (ZF) bereitstellt,
- einem Mittel zum Bereitstellen des Amplitudenmodulationssignals (AS) durch Amplitudenvergleich von Eingangssignal und Zwischenfrequenz-Signal und
- einem Mittel zum Bereitstellen des Phasenvergleichssignals (PS) durch Phasenvergleich von Eingangssignal und Zwischenfrequenz-Signal,
**gekennzeichnet durch**
- einen Verstärker (PV), der eingangsseitig mit dem Ausgang des Amplitudenmodulators (AM) und ausgangsseitig mit einem Eingang des ersten Mischers (M1) verbunden ist und der einen Steueranschluß (S) zur Zuführung eines Steuersignals hat, wobei
- das Mittel zum Bereitstellen des Phasenvergleichssignals (PS) einen Phasen- und Frequenzdetektor (PFD) mit nachgeschaltetem Tiefpaß-Filter (TP) umfaßt, sowie einen ersten Limiter (LIM1), dem das Zwischenfrequenz-Signal zuführbar ist, und einen zweiten Limiter (LIM2), dem das Eingangssignal zuführbar ist, wobei die Limiter (LIM1, LIM2) ausgangsseitig an je einen Eingang des Phasen- und Frequenzdetektors (PFD) anschließbar sind, und wobei
- ein Bypass-Zweig (BP) vorgesehen ist, der einen zweiten Mischer (M2) umfaßt, der an den Ausgang des Oszillators (VCO) angeschlossen ist und an seinem Ausgang ein weiteres Zwischenfrequenz-Signal bereitstellt, welches dem Phasen- und Frequenzdetektor (PFD) an einem Eingang zuführbar ist.

2. Polar-Loop-Sendeschaltung nach Anspruch 1,
**dadurch gekennzeichnet, daß**
der Amplitudenmodulator (AM) ein nichtlinearer, regelbarer Verstärker ist.

3. Polar-Loop-Sendeschaltung nach Anspruch 1 oder 2,
**dadurch gekennzeichnet, daß**
der Verstärker (PV) ein programmierbarer Verstärker ist, der das Ausgangssignal der Sendeschaltung dämpft.

4. Polar-Loop-Sendeschaltung nach einem der Ansprüche 1 bis 3,
**dadurch gekennzeichnet, daß**
dem Steueranschluß (S) ein Steuersignal zur Regelung der Leistung des Ausgangssignals zuführbar ist.

5. Polar-Loop-Sendeschaltung nach einem der Ansprüche 1 bis 4,
**dadurch gekennzeichnet, daß**
ein Schalter (SW) vorgesehen ist, der in einem Einstellbetrieb den Ausgang des zweiten Mischers (M2) mit einem Eingang des Phasen- und Frequenzdetektors (PFD) verbindet und in einem Sendebetrieb einen Ausgang des ersten Limiters (LIM1) mit einem Eingang des Phasen- und Frequenzdetektors (PFD) verbindet.

6. Polar-Loop-Sendeschaltung nach einem der Ansprüche 1 bis 5,
**dadurch gekennzeichnet, daß**
das Mittel zum Bereitstellen des Amplitudenmodulationssignals (AS) einen Differenzverstärker (DV) mit einem Plus-Eingang und einem Minus-Eingang und mit nachgeschaltetem Tiefpaß-Filter (TP) umfaßt, wobei dem Plus-Eingang das gleichgerichtete Eingangssignal und dem Minus-Eingang das gleichgerichtete Zwischenfrequenz-Signal zuführbar ist.

7. Polar-Loop-Sendeschaltung nach Anspruch 6,
**dadurch gekennzeichnet, daß**
zur Gleichrichtung von Eingangs- und Zwischenfrequenz-Signal je ein Diodengleichrichter (SG1, SG2) vorgesehen ist.

8. Polar-Loop-Sendeschaltung nach Anspruch 6,
**dadurch gekennzeichnet, daß**
zur Gleichrichtung von Eingangs- und Zwischenfrequenz-Signal je ein Synchrongleichrichter (SG1, SG2) vorgesehen ist, die ausgangsseitig mit je einem Eingang des Differenzverstärkers (DV) gekoppelt sind.

9. Polar-Loop-Sendeschaltung nach einem der Ansprüche 1 bis 8,
**dadurch gekennzeichnet, daß**
im Rückkopplungspfad (RK) ein Ramping-Verstärker (PR) vorgesehen ist, der als linearer, regelbarer Verstärker ausgeführt ist zum Einregeln der Leistung des Ausgangssignals zu Beginn und zu Ende von Sende-Zeitschlitzen.

## Revendications

1. Circuit d'émission à boucle polaire comprenant
- un générateur (SSB) qui procure un signal d'entrée ;
- un oscillateur (VCO) de production d'un signal de haute fréquence à sa sortie en fonction d'un signal (PS) de comparaison de phase ;
- un modulateur (AM) d'amplitude qui est raccordé à la sortie de l'oscillateur (VCO) et qui procure à sa sortie (OUT) en fonction d'un signal (AS) de modulation d'amplitude un signal de sortie dérivé du signal de haute fréquence ;
- un trajet (RK) de réaction comprenant un premier mélangeur (M1) qui procure à sa sortie un signal (ZF) de fréquence intermédiaire dérivé du signal de sortie ;
- un moyen pour procurer le signal (AS) de modulation d'amplitude par comparaison de l'amplitude du signal d'entrée et de l'amplitude du signal de fréquence intermédiaire; et
- un moyen pour procurer le signal (PS) de comparaison de phase par comparaison de la phase du signal d'entrée et de la phase du signal de fréquence intermédiaire,
**caractérisé par**
- un amplificateur (PV) qui est relié du côté de l'entrée à la sortie du modulateur (AM) d'amplitude et du côté de la sortie à une entrée du premier mélangeur (M1) et qui a une borne (S) de commande pour l'envoi d'un signal de commande, dans lequel
- le moyen pour procurer le signal (PS) de comparaison de phase comprend un détecteur (PFD) de phase et de fréquence ayant un filtre (TP) passe-bas en aval ainsi qu'un premier limiteur (LIM1) auquel peut être envoyé le signal de fréquence intermédiaire et un deuxième limiteur (LIM2) auquel peut être envoyé le signal d'entrée, les limiteurs (LIM1, LIM2) pouvant être raccordés du côté de la sortie à, respectivement, une entrée du détecteur (PFD) de phase et de fréquence ; et dans lequel
- il est prévu une branche (BP) de dérivation qui comprend un deuxième mélangeur (M2) qui est raccordé à la sortie de l'oscillateur (VCO) et qui procure sur sa sortie un autre signal de fréquence intermédiaire qui peut être envoyé au détecteur (PFD) de phase et de fréquence à une entrée.

2. Circuit d'émission à boucle polaire suivant la revendication 1, **caractérisé en ce que** le modulateur (AM) d'amplitude est un amplificateur réglable non linéaire.

3. Circuit d'émission à boucle polaire suivant la revendication 1 ou 2, **caractérisé en ce que** l'amplificateur (PV) est un amplificateur programmable qui atténue le signal de sortie du circuit d'émission.

4. Circuit d'émission à boucle polaire suivant l'une des revendications 1 à 3, **caractérisé en ce qu'**un signal de commande pour la régulation de la puissance du signal de sortie peut être envoyé à la borne (S) de commande.

5. Circuit d'émission à boucle polaire suivant l'une des revendications 1 à 4, **caractérisé en ce qu'**il est prévu un commutateur (SW) qui, dans un fonctionnement d'arrêt, relie la sortie du deuxième mélangeur (M2) à une entrée du détecteur (PFD) de phase et de fréquence et, dans un fonctionnement d'émission, relie une sortie du premier limiteur (LIM1) à une entrée du détecteur (PFD) de phase et de fréquence.

6. Circuit d'émission à boucle polaire suivant l'une des revendications 1 à 5, **caractérisé en ce que** le moyen pour procurer le signal (AS) de modulation d'amplitude comprend un amplificateur (DV) différentiel ayant une entrée positive et une entrée négative et un filtre (TP) passe-bas en aval, le signal d'entrée redressé pouvant être envoyé à l'entrée positive et le signal de fréquence intermédiaire redressé pouvant être envoyé à l'entrée négative.

7. Circuit d'émission à boucle polaire suivant la revendication 6, **caractérisé en ce qu'**il est prévu un redresseur (SG1, SG2) à diode pour redresser, respectivement, le signal d'entrée et le signal de fréquence intermédiaire.

8. Circuit d'émission à boucle polaire suivant la revendication 6, **caractérisé en ce que**, pour redresser le signal d'entrée et le signal intermédiaire, il est prévu respectivement un redresseur (SG1, SG2) synchrones qui sont couplés du côté de la sortie à, respectivement, une entrée de l'amplificateur (DV) différentiel.

9. Circuit d'émission à boucle polaire suivant l'une des revendications 1 à 8, **caractérisé en ce qu'**il est prévu dans le trajet (RK) de réaction un amplificateur (PR) ramping qui est réalisé sous la forme d'un amplificateur réglable linéaire pour régler la puissance du signal de sortie au début et à la fin des créneaux temporels d'émission.

## Claims

1. Polar-loop transmission circuit having
- a generator (SSB) which provides an input signal,
- an oscillator (VCO) for generating a radio-frequency signal at its output as a function of a phase comparison signal (PS),
- an amplitude modulator (AM) which is connected to the output of the oscillator (VCO) and provides an output signal, which is derived from the radio-frequency signal, at its output (OUT) as a function of an amplitude modulation signal (AS),
- a feedback path (RK) having a first mixer (M1) which provides, at its output, an intermediate frequency signal (ZF) that is derived from the output signal,
- a means for providing the amplitude modulation signal (AS) by comparing the amplitude of the input signal and of the intermediate frequency signal, and
- a means for providing the phase comparison signal (PS) by comparing the phase of the input signal and of the intermediate frequency signal,
**characterized by**
- an amplifier (PV) which is connected, on the input side, to the output of the amplitude modulator (AM) and, on the output side, to an input of the first mixer (M1) and which has a control connection (S) for supplying a control signal,
- the means for providing the phase comparison signal (PS) comprising a phase and frequency detector (PFD) with a downstream low-pass filter (TP) as well as a first limiter (LIM1), to which the intermediate frequency signal can be supplied, and a second limiter (LIM2), to which the input signal can be supplied, it being possible for the limiters (LIM1, LIM2) to be connected, on the output side, to a respective input of the phase and frequency detector (PFD), and
- provision being made of a bypass branch (BP) comprising a second mixer (M2) which is connected to the output of the oscillator (VCO) and provides, at its output, a further intermediate frequency signal that can be supplied to an input of the phase and frequency detector (PFD).

2. Polar-loop transmission circuit according to Claim 1,
**characterized in that**
the amplitude modulator (AM) is a non-linear adjustable amplifier.

3. Polar-loop transmission circuit according to Claim 1 or 2,
**characterized in that**
the amplifier (PV) is a programmable amplifier which attenuates the output signal from the transmission circuit.

4. Polar-loop transmission circuit according to one of Claims 1 to 3,
**characterized in that**
a control signal for adjusting the power of the output signal can be supplied to the control connection (S).

5. Polar-loop transmission circuit according to one of Claims 1 to 4,
**characterized in that**
provision is made of a switch (SW) which, in an adjustment mode, connects the output of the second mixer (M2) to an input of the phase and frequency detector (PFD) and, in a transmission mode, connects an output of the first limiter (LIM1) to an input of the phase and frequency detector (PFD).

6. Polar-loop transmission circuit according to one of Claims 1 to 5,
**characterized in that**
the means for providing the amplitude modulation signal (AS) comprises a differential amplifier (DV) having a non-inverting input and an inverting input and having a downstream low-pass filter (TP), it being possible for the rectified input signal to be supplied to the non-inverting input and for the rectified intermediate frequency signal to be supplied to the inverting input.

7. Polar-loop transmission circuit according to Claim 6,
**characterized in that**
a respective diode rectifier (SG1, SG2) is provided for the purpose of rectifying the input signal and the intermediate frequency signal.

8. Polar-loop transmission circuit according to Claim 6,
**characterized in that**
a respective synchronous rectifier (SG1, SG2) is provided for the purpose of rectifying the input signal and the intermediate frequency signal, said rectifiers being coupled, on the output side, to a respective input of the differential amplifier (DV).

9. Polar-loop transmission circuit according to one of Claims 1 to 8,
**characterized in that**
a ramping amplifier (PR) which is in the form of a linear adjustable amplifier and is intended to adjust the power of the output signal at the beginning and end of transmission time slots is provided in the feedback path (RK).
